Europäisches Patentamt

European Patent Office

Office européen des brevets

(11) Veröffentlichungsnummer: **0 277 272**
**A2**

(12) **EUROPÄISCHE PATENTANMELDUNG**

(21) Anmeldenummer: **87111730.5**

(22) Anmeldetag: **13.08.87**

(51) Int. Cl.4: **H03H 9/19**

(30) Priorität: **04.02.87 DE 3703241**

(43) Veröffentlichungstag der Anmeldung:
**10.08.88 Patentblatt 88/32**

(84) Benannte Vertragsstaaten:
**CH DE FR GB IT LI NL**

(71) Anmelder: **W.C. Heraeus GmbH**
**Heraeusstrasse 12 - 14**
**D-6450 Hanau / Main(DE)**

(72) Erfinder: **Ziegler, Horst, Prof. Dr.**
**Steinhauser Weg 13**
**D-4790 Paderborn(DE)**

(74) Vertreter: **Heinen, Gerhard, Dr.**
**Heraeus Holding GmbH Heraeusstrasse**
**12-14**
**D-6450 Hanau am Main(DE)**

(54) **Temperaturempfindlicher Schwingquarz.**

(57) Ein temperaturempfindlicher Schwingquarz 1 weist zwei zueinander parallele Oberflächen 2 von annähernd gleicher Größe auf, die mit einem durch je eine elektrische, mechanische Achse und optische Achse gebildeten x-y-z-Koordinatensystem des Quarz-Kristalls einen vorgegebenen Schnittwinkel bilden; der von einer der beiden Oberflächen 2 und der elektrischen (x-)Achse eingeschlossene Winkel $\varnothing$ liegt dabei innerhalb eines Toleranzbereiches von +1° und -1° während der von einer der beiden Oberflächen 2 und der optischen (z-)Achse einge-schlossene Winkel $\Theta$ entweder im Bereich von 3 bis 6° oder im Bereich von 68 bis 72° liegt.

Da im Bereich von $\Theta \approx 4°$ und $\Theta \approx 70°$ die Änderung des Temperaturkoeffizienten pro Änderung des Winkels $\Theta$ aufgrund der Maximum-bzw. Minimumcharakteristik nur verhältnismäßig gering ist, können in der Serienfertigung Schwing-quarze innerhalb eines technisch gut zu handhabenden Toleranzbereiches mit praktisch konstantem Temperaturkoeffizienten hergestellt werden.

Fig. 1

### "Temperaturempfindlicher Schwingquarz"

Die Erfindung betrifft einen temperaturempfindlicher Schwingquarz mit wenigstens zwei zueinander parallelen Oberflächen von annähernd gleicher Größe, die mit einem durch je eine elektrische, mechanische und optische Achse gebildeten x-y-z-Koordinatensystem des Quarz-Kristalls einen vorgegebenen Schnittwinkel bilden, wobei der von einer der beiden Oberflächen und der elektrischen (x-)Achse eingeschlossene Winkel Ø innerhalb eines des Winkel 0° einschließenden Toleranzbereiches liegt.

Aus der US-PS 3,486,023 ist ein temperatursensitiver Quarz bekannt, der aufgrund des sogenannten y-Schnittes einen hohen Temperaturkoeffizienten aufweist. Y-Schnitt bedeutet hierin, daß der Schnitt durch die sogenannte y-Ebene verläuft, welche von der x-und z-Achse aufgespannt wird; dies bedeutet, daß der von der Schnittfläche und der elektrischen x-Achse eingeschlossene Winkel Ø 0° beträgt, dies gilt auch für den von der Schnittfläche und der optischen z-Achse eingeschlossene Winkel $\oslash$ . Da im Bereich $\oslash$ = 0 der aus Temperaturkoeffizientänderung pro Winkeländerung gebildete Differenzenquotient verhältnismäßig groß ist, muß zwecks eindeutiger Zuordnung der erzeugten Frequenz zur Temperatur ein möglichst präziser Schnitt innerhalb eines sehr engen Toleranzbereiches erfolgen; anderenfalls müßte die Abhängigkeit der Frequenz von der Temperatur bei jedem einzelnen Quarz vor seinem Einsatz ermittelt werden.

Die Erfindung stellt sich die Aufgabe, Schwingquarze, insbesondere von Typ des Dickenschwingers, mit einem möglichst großen Temperaturkoeffizienten zu schaffen, wobei in einer Serienfertigung möglichst geringe Exemplarstreuungen auftreten sollen.

Die Aufgabe wird erfindungsgemäß durch die kennzeichnenden Merkmale des Anspruchs 1 gelöst.

In einer bevorzugten Ausführungsform sind die zueinander parallelen Oberflächen kreisförmig ausgebildet, wobei jeweils die Mittelpunkte der beiden Kreisflächen auf einer gemeinsamen, sie senkrecht durchsetzenden Achse liegen und die zwischen beiden Oberflächen befindliche Ummantelung eine nach außen gerichtete, sich über ihren gesamten Umfang erstreckende Ausbuchtung aufweist.

Als vorteilhaft erweist sich nach der Erfindung, daß insbesondere in der Großserienfertigung hergestellte Schwingquarze innerhalb eines technisch gut zu handhabenden Toleranzbereiches mit praktisch konstantem Temperaturkoeffizienten hergestellt werden können, so daß mit solchen Quarzen ausgestattete Temperatursensoren nach eine Einpunkt-Kalibration bzw. Nullpunkt-Kalibration an vorgegebene Auswerteeinheiten angeschlossen werden können; dabei erweist sich insbesondere die einfache Austauschbarkeit von Temperatursensoren als vorteilhaft.

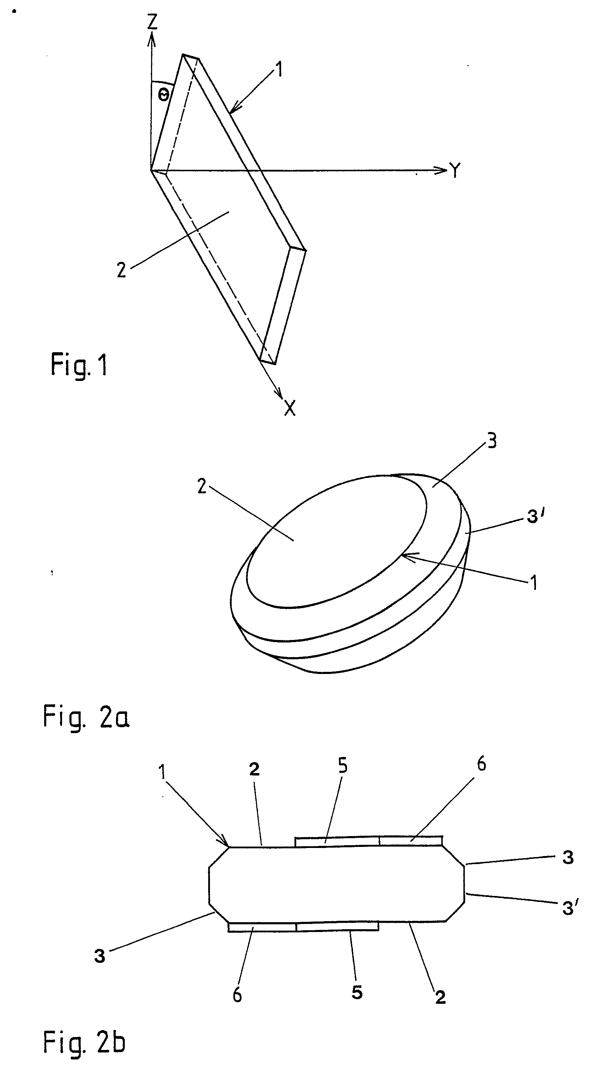

Im folgenden ist der Gegenstand der Erfindung anhand der Figuren 1 bis 3 näher erläutert.

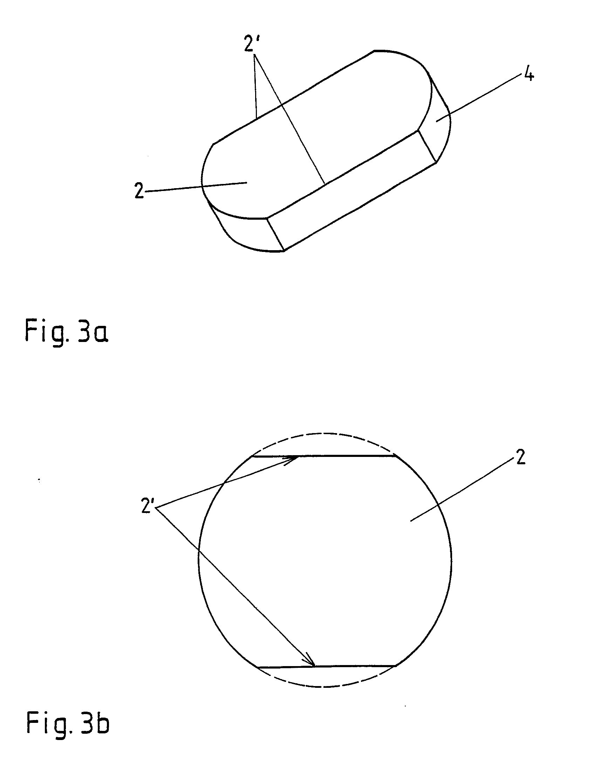

Figur 1 zeigt die Schnittebene der Oberfläche in der durch Koordinaten angedeuteten kristallinen Struktur des Quarzes; Figur 2a zeigt einen mit kreisförmigen Oberflächen versehenen Schwingquarz, während Figur 2b einen Querschnitt durch den Quarz dargestellt. Figur 3a zeigt einen Schwingquarz mit segmentierten Kreisflächen, wobei die geometrischen Verhältnisse anhand der Figur 3b erläutert sind.

Gemäß Figur 1 entspricht die x-Achse des Koordinatensystems der elektrischen, die y-Achse der mechanischen und die z-Achse der optischen Achse der Kristallstruktur des Quarzes. Der von der Ebene der Oberfläche 2 des Quarzes 1 und der x-Achse eingeschlossene Schnittwinkel Ø liegt zwischen 1 und -1°, während der von der Ebene der Oberfläche 2 und der z-Achse eingeschlossene Winkel $\oslash$ im Bereich von 3 bis 6° oder im Bereich von 68 bis 72° liegt; vorzugsweise leist der Schnittwinkel Ø im Bereich zwischen 15' und -15', während der Winkel $\oslash$ im Bereich von 4° 8' ±3' bzw. im Bereich von 70° ±3' liegt. Im Bereich von $\oslash$ ≈ 4° weist der Temperaturkoeffizient ein Maximum auf, wobei auch gerinfügig über oder unter dem Wert 4° liegende Schnittwinkel nur eine äußerst geringe Änderung des Temperaturkoeffizienten erkennen lassen; weiterhin weist der Temperaturkoeffizient im Bereich von $\oslash$ ≈70° ein ausgeprägtes Minimum auf, so daß auch in diesem Bereich eine Toleranzzone mit äußerst geringer Änderung des Temperaturkoeffizienten vorliegt; zwischen diesen beiden Winkeln befindet sich bei $\oslash$ ≈ 30° ein Nulldurchgang der Funktion des Temperaturkoeffizienten, d.h. in diesem Punkt haben Temperaturänderungen keinen Einfluß auf das Schwingverhalten des Quarzes.

Gemäß Figur 2a weist der Quarz zwei kreisrunde, ebene Oberflächen 2 auf, die zueinander axial angeordnet sind. Zwischen beiden Oberflächen ist eine sich über des gesamten Umfang erstreckende, facettierte Mantelfläche 3 angeordnet, durch die eine hohe Güte des Schwingquarzes erzielt werden soll. Die Facettierung besteht aus einer umlaufenden, trapezförmigen Ausbuchtung, wodurch sich der Querschnitt gemäß Figur 2b als breitgezogenes Achteck darstellt. Der Quarz 1 weist einen Durchmesser von ca. 4,5 mm auf und eine Stärke von etwa 0,1 mm; die Frequenz beträgt

16,75 mHz ±50 kHz bei einer Temperatur von 25 °C, wobei eine Güte von wenistens 5000 erzielt wird.

Zum Einsatz als Temperatursensor werden die Oberflächen 2 durch Massenbedampfung mit Silberelektroden 5 versehen. Die Elektroden 5 überlappen sich im Inneren der Scheibe kreisförmig und haben seitliche Auswüchse 6 nach mehreren Seiten, um eine seitliche Kontaktierung durch die hier nicht dargestellten im Temperatursensorgehäuse befindlichen Klemmfedern zu gewährleisten. Die Elektroden 5 sind zwecks besserer Übersicht in Figur 2b überproportional dargestellt. Der Quarz wird durch hochtemperaturfeste Leitfähigkeitskleber in den Klemmfedern gehalten; der Quarz ist von einer Argon-Schutzgasatmosphäre im hermetisch dichten Edelstahlgehäuse umgeben. Die Außenseite des Edelstahlgehäuses ist glatt und damit für die industrielle Temperaturmeßtechnik geeignet; Gehäuseboden und anschließende Rohre sind lasergeschweißt, wobei der Gehäuseboden zwei Druckglasdurchführungen für Anschlußstifte enthält. Die Klemmfedern im Inneren des Gehäuses sind mit den Anschlußstiften durch Punktschweißung verbunden.

Der Arbeitsbereich des Systems liegt bei Temperaturen zwischen -40 und +300 °C.

Eine weitere Form des Quarzes 1 ist in Figur 3a dargestellt; die Oberflächen 2 weisen die Form von segmentierten Kreisen gemäß Figur 3b auf, wobei jeweils zwei Sekanten 2' sich gegenüberliegen und parallel verlaufen. Durch die Segmentierung weist dieser Quarz eine ähnlich hohe Güte auf wie der anhand der Figur 2 beschriebene, wobei auf eine Facettierung der Mantelfläche 4 verzichtet werden kann. Die Elektrodenaufbringung und Halterung im Temperatursensorgehäuse entsprechen der anhand der Figur 2 erläuterten Ausführungsform.

## Ansprüche

1. Temperaturempfindlicher Schwingquarz mit wenigstens zwei zueinander parallelen Oberflächen von annähernd gleicher Größe, die mit einem durch je eine elektrische, mechanische und optische Achse gebildeten x-y-z-Koordinatensystem des Quarz-Kristalls einen vorgegebenen Schnittwinkel bilden, wobei der von einer der beiden Oberflächen und der elektrischen (x-)Achse eingeschlossene Winkel Ø innerhalb eines den Winkel 0° einschließenden Toleranzbereiches liegt, dadurch gekennzeichnet, daß der Toleranzbereich des Winkels Ø zwischen +1° und -1° liegt und daß der von einer der Oberflächen und der optischen (z-)Achse eingeschlossene Winkel ☉ entweder im Bereich von 3 bis 6° oder im Bereich von 68 bis 72° liegt.

2. Schwingquarz nach Anspruch 1, dadurch gekennzeichnet, daß die zueinander parallelen Oberflächen (2) kreisförmig ausgebildet und zueinander axial angeordnet sind, wobei jeweils die Mittelpunkte der beiden Kreisflächen auf einer gemeinsamen, sie senkrecht durchsetzenden Achse liegen.

3. Schwingquarz nach Anspruch 2, dadurch gekennzeichnet, daß die im Bereich der Mitte des Abstandes der beiden Oberflächen die zwischen den beiden Oberflächen befindliche Mantelfläche (3) eine nach außen gerichtete, sich über ihren gesamten Umfang erstreckende Ausbuchtung (3') aufweist.

4. Schwingquarz nach Anspruch 3, dadurch gekennzeichnet, daß die Ausbuchtung (3') trapezförmig ausgebildet ist.

5. Schwingquarz nach Anspruch 1, dadurch gekennzeichnet, daß die Oberflächen (2) als segmentierte Kreise mit sich gegenüberliegenden, parallelen Sekanten (2') ausgebildet sind, die zueinander kongruent sind.

Z

Θ

1

2

Y

**Fig. 1**

X

3

2

3'

1

**Fig. 2a**

1  2  5  6

3

3'

3

6  5  2

**Fig. 2b**

Fig. 3a

Fig. 3b